# EUROPEAN PATENT SPECIFICATION

(11) **EP 0 417 329 B1**
(45) Date of publication and mention of the grant of the patent: **28.12.1994**
(21) Application number: 90905662.4
(22) Date of filing: 29.03.1990
(51) Int. Cl.: H01B 13/00, H01F 5/08, H01L 39/14

(54) **METHOD OF PRODUCING AN OXIDE SUPERCONDUCTING WIRE**
VERFAHREN ZUR HERSTELLUNG EINES SUPRALEITENDEN DRAHTES AUF OXIDBASIS
PROCEDE DE FABRICATION D'UN FIL A SUPERCONDUCTEUR D'OXIDE

(30) Priority: 31.03.1989 JP 82556/89; 12.07.1989 JP 179423/89
(43) Date of publication of application: 20.03.1991
(73) Proprietor: SUMITOMO ELECTRIC INDUSTRIES, LTD., Osaka-shi, Osaka 541 (JP); THE KANSAI ELECTRIC POWER CO., INC., Osaka-shi, Osaka 530 (JP)
(72) Inventor: HAYASHI, Noriki Osaka Works - Sumitomo Electric, Osaka-shi Osaka 554 (JP); TAKANO, Satoshi Osaka Works - Sumitomo Electric, Osaka-shi Osaka 554 (JP); OKUDA, Shigeru Osaka Works - Sumitomo Electric, Osaka-shi Osaka 554 (JP); HITOTSUYANAGI, Hajime Osaka Works - Sumitomo, Konohana-ku Osaka-shi Osaka 554 (JP)
(74) Representative: KUHNEN, WACKER & PARTNER
(86) International application number: JP9000421
(87) International publication number: WO9012409

(56) References cited:
- EP-A- 0 312 015
- EP-A- 0 357 910
- JP-A- 159 713
- JP-A- 159 714
- JP-A- 159 728
- JAPANESE JOURNAL OF APPLIED PHYSICS LETTERS vol. 27, no. 6, June 1988, TOKYO,JP pages 1092 - 1093; T.KONAKA ET AL: 'Preparation of Y-Ba-Cu-O SuperconductingTape by Atmospheric Plasma Spraying'
- PATENT ABSTRACTS OF JAPAN vol. 13, no. 99 (E-724)8 March 1989
- IBM TECHNICAL DISCLOSURE BULLETIN vol. 32, no. 4B, September 1989, NEW YORK, USpages 85 - 86; 'Superconducting ceramic-metal structure'
- PATENT ABSTRACTS OF JAPAN vol. 13, no. 254 (E-772)13 June 1989

## Description

### TECHNICAL FIELD

The present invention relates to a method for producing oxide superconductive wires particularly suited for products such as coils using the oxide superconductive wires.

### BACKGROUND ART

When oxide superconductive materials are to be used for coils or cables, the superconductive materials must be lengthened, and the lengthened materials should have some flexibility.

A method of forming an oxide superconductive layer on a longitudinal base having flexibility has been known as a method of lengthening oxide superconductive material satisfying the above-mentioned condition, that is, a method of providing an oxide superconductive wire having some flexibility. A gas phase thin film deposition such as vapor deposition, sputtering, CVD may be applied as a method of forming the oxide superconductive layer.

The oxide superconductive material is generally weak on strain, especially tensile strain, and when tensile strain is applied, superconductivity such as critical temperature and electric current density is significantly degraded.

As to the tensile strain, if the strain exceeds a prescribed magnitude, the superconductivity before the application of the tensile strain cannot be recovered even when the tensile strain is removed. Conversely, if the tensile strain is smaller than the prescribed magnitude, the superconductivity before the application of the tensile strain can be recovered when the tensile strain is removed.

When an oxide superconductive layer is formed on a longitudinal base having flexibility so as to provide an oxide superconductive wire, as described above, the oxide superconductive layer is subjected to at least one step of heating. Therefore, the longitudinal base used for forming the oxide superconductive layer thereon must be formed of a material which withstands such step of heating and it should not be subject to undesirable diffusion or reaction with the oxide superconductive layer during the step of heating. As the longitudinal base, YSZ (yttria stabilized zirconia) is advantageously used, for example. There are materials other than YSZ suitable for the longitudinal base on which the oxide superconductive layer is formed.

The above-described oxide superconductive wire having the oxide superconductive layer formed on the longitudinal base must be wound around a bobbin in a preparatory step before succeeding processing such as enamel paint application or in the step of forwarding, for example. In providing products using the oxide superconductive wires, when coils are to be provided, for example, the oxide superconductive wire must be wound in coils, and when cables are to be provided, for example, the oxide superconductive wires must be wound spirally on a surface of a longitudinal pipe. In any treatment of the oxide conductive wires, they are bent inevitably. It should be understood that a strain is generated in the oxide superconductive layer unavoidably, when the oxide superconductive wire is bent. As described above, the strain may cause the degradation of the superconductivity of the oxide superconductive material constituting the oxide superconductive layer.

From prior art document EP-A-0 357 910 (which is a prior art document in accordance with Art. 54(3) EPC) a method is known for producing oxide superconductive conductors. According to this prior art approach a metal tape serving as flexible longitudinal base is provided, the metal tape being bent to form a metal tubing and welded by an automatic welding apparatus. According to the different embodiments discussed, an oxide superconductive material is applied either on the inner surface of the metal tube (before the metal tape is bended and welded), or on the outer surface of the metal tube (after welding). Subsequently, the metal tube is fed through a bellows forming section pressing the metal tube such that it assumes a bellows-like shape. Finally, the resulting bellows-like metal tube is directed through an oven heating the tube to provide for the oxide superconductive layer either on the outer or the inner surface of the tube. The thus provided superconductive conductor may be economically produced and may be wound around a bobbin since due to the bellows-like shape of the conductor it is relatively insensitive against tensile strain.

In view of the above it is the object of the present invention to provide a method for producing an oxide superconductive wire which prevents, as much as possible, the degradation of the above described superconductivity of the oxide superconductive layer.

This object is solved by a method for producing an oxide superconducting wire in accordance with claim 1.

In more detail, the present invention relates to a method for producing an oxide superconducting wire consisting of an oxide superconducting layer on a flexible longitudinal base, wherein the thermal expansion coefficient of the longitudinal base is smaller than that of the oxide superconductive layer. The method comprises in sequence the following steps:
a) applying an oxide superconductive material to said flexible longitudinal base and heating the resulting material-base structure to form an oxide superconducting wire,
b) bending the superconducting wire such that the superconducting layer being positioned inside and said longitudinal base being positioned outside about a flexural center.

The present invention aims to provide products in which the degradation of superconductivity of the oxide superconductive layer is prevented as much as possible.

The inventors of the present invention were aware that the oxide superconductive material is generally weak on strains. However, the inventors found that when an oxide superconductive wire having an oxide superconductive layer formed at least by a step of heating on a certain flexible longitudinal base is bent in a certain direction, the superconductivity is hardly degraded or rather improved, although a strain has been inevitably generated in the oxide superconductive layer. As a result of investigation of the reason, it turned out that this was derived from the difference between the thermal expansion coefficient of the longitudinal base and the thermal expansion coefficient of the material of the oxide superconductive layer. More specifically, most of the flexible longitudinal bases suitable for forming the oxide superconductive layers to provide oxide superconductive wires at present have thermal expansion coefficients smaller than that of the oxide superconductive layers.

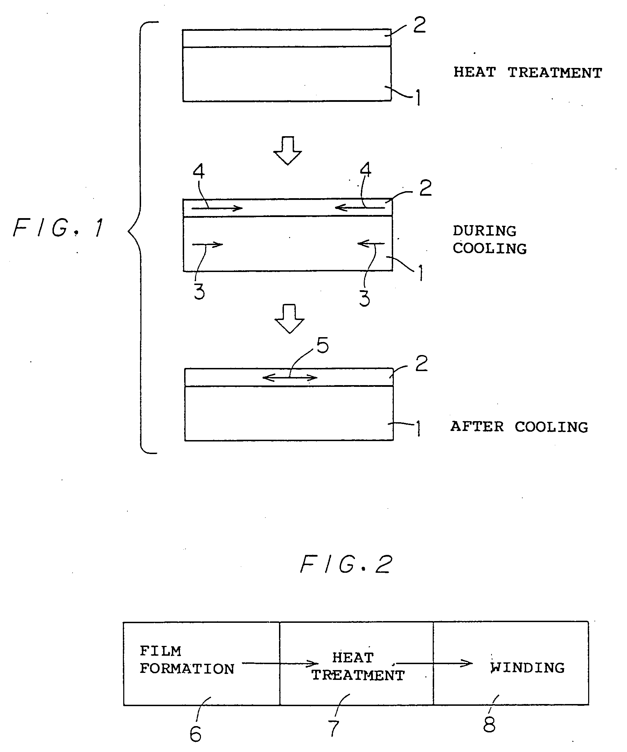

Referring to Fig. 1, when an oxide superconductive layer 2 is formed on a longitudinal base 1, it is subjected to a step of heating at a temperature of 400 to 1000°C, for example. After a desired oxide superconductive layer 2 is formed, the oxide superconductive layer 2 as well as the longitudinal base 1 are cooled. During cooling, contraction represented by an arrow 3 is generated in the longitudinal base 1, while contraction represented by an arrow 4 is generated in the oxide superconductive layer 2. The arrow 3 is shorter than the arrow 4 so as to indicate that the thermal expansion coefficient of the longitudinal base 1 is smaller than that of the oxide superconductive layer 2. Therefore, after cooling, a tensile strain is applied to the oxide superconductive layer 2 as shown by an arrow 5, due to the difference of the thermal expansion coefficients.

As shown in Fig. 1, the present invention is aimed at an oxide superconductive wire in which the thermal expansion coefficient of the longitudinal base 1 is smaller than that of the material of the oxide superconductive layer 2.

In the present invention, in order to solve the above-described technical problem, the oxide superconductive wire is bent with the oxide superconductive layer positioned inside and the longitudinal base positioned outside about a flexural center in treating the oxide superconductive wire. Referring again to Fig. 1, according to the characteristic method of treating described above, the tensile strain represented by the arrow 5 which has been applied to the oxide superconductive layer 2 can be released.

In the present invention, a tape-type longitudinal base is preferably used.

Zirconia, alumina, glass, titanium, zirconium, tungsten, platinum, chromium, nickel, niobium, molybdenum, iron, stainless steel and nickel alloy are examples of the materials of the longitudinal base satisfying the above described condition of the thermal expansion coefficient.

In the present invention, products using the above-described oxide superconductive wires are provided. In these products, the oxide superconductive wires are bent such that the superconductive layer is positioned inside and the longitudinal base is positioned outside about the flexural center.

Examples of the above-described products are coils using the oxide superconductive wires, bobbins with the oxide superconductive wires wound therearound and cables having the oxide superconductive wires wound spirally on a surface of a longitudinal body.

According to the present invention, the oxide superconductive wire is treated such that the tensile strain unavoidably remaining in the oxide superconductive layer included therein is released, so that degradation of superconductivity of the oxide superconductive layer can be prevented. According to the present invention, not only degradation of superconductivity is prevented but in some cases, the superconductivity can be rather improved. Further, as described above, the tensile strain provided in advance in the oxide superconductive layer is released, and in some cases a compressive strain is generated when the oxide superconductive wire is bent. However, such compressive strain does not so much affect the superconductivity as the tensile strain, and it has been found that such compressive strain may improve the superconductivity.

In the present invention, a tape-type longitudinal base facilitates bending of the oxide superconductive wire in a desired direction.

The superconductivity of the oxide superconductive wires can be fully utilized in products such as coils and cables and in intermediate products such as bobbins provided by the method of treating in accordance with the present invention.

### BRIEF DESCRIPTION OF THE DRAWINGS

Fig. 1 shows influence of thermal expansion coefficient in the process of manufacturing oxide superconductive wires, on which the present invention is based;
Fig. 2 schematically shows an apparatus used in Embodiment 1 of the present invention;
Fig. 3 is a front view showing a bobbin 9 arranged in a winding chamber 8 shown in Fig. 2;
Fig. 4 is an enlarged cross sectional view showing an oxide superconductive wire 11 wound around a core 10 of the bobbin 9 shown in Fig. 3;
Fig. 5 is a front view showing a portion of a coil 18 provided by Embodiment 2 of the present invention; and
Fig. 6 is a cross sectional view showing, in enlargement, a portion of an oxide superconductive wire 14 included in the coil 18 shown in Fig. 5.

### BEST MODES FOR CARRYING OUT THE INVENTION

### Embodiment 1

A film of Y-Ba-Cu-O superconductive material having thickness of 1 µm is formed on a tape-type longitudinal base (having the width of 5 mm and thickness of 0.1 mm) of stabilized zirconia, by laser deposition. The conditions of forming the film were as follows.
Target composition: Y₁ Ba₂ Cu₃ Oₓ
Temperature of film formation : 750°C
Gas pressure: 0.1 Torr
Gas: O₂
Laser wave length: 193 nm
Energy density: 1 J/cm²

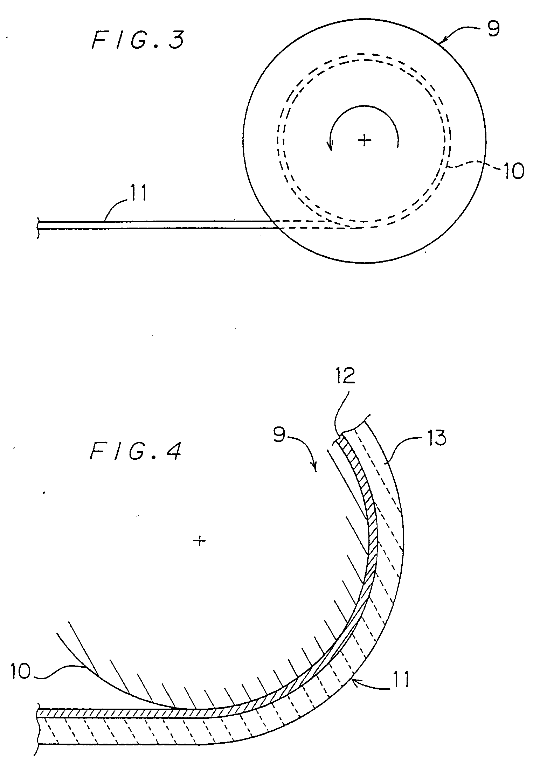

The above described film formation was carried out in a film forming chamber 6, and then heat treatment of the provided oxide superconductive wire was carried out, with the moving velocity of longitudinal base of 4 cm/hour, for 10 minutes at 900°C in a heat processing chamber 7, as shown in Fig. 2. Then the oxide superconductive wire 11 was wound for 5 turns on a core 10 of a bobbin 9 in a winding chamber 8, as shown in Figs. 3 and 4. At this time, the wire was wound such that the oxide superconductive layer 12 was positioned inside and the longitudinal base 13 was positioned outside, as shown in Fig. 4. The diameter of the core 10 was 30 mm.

The oxide superconductive wire 11 wound around the bobbin 9 was dipped in liquid nitrogen, and measured critical current was 5 A.

### Reference Example 1

The oxide superconductive wire 11 was treated in the same manner as in above described embodiment 1 except that the oxide superconductive wire 11 was wound around the core 10 of the bobbin 9 with the oxide superconductive layer 12 positioned outside, and the critical current of the oxide superconductive wire 11 wound around the bobbin 9 was measured under the same condition, which was 2 A.

### Embodiment 2

An oxide superconductive wire was provided by using the same longitudinal base under the same conditions of film formation as Embodiment 1. A superconductive coil was fabricated in the following manner by using the oxide superconductive wire.

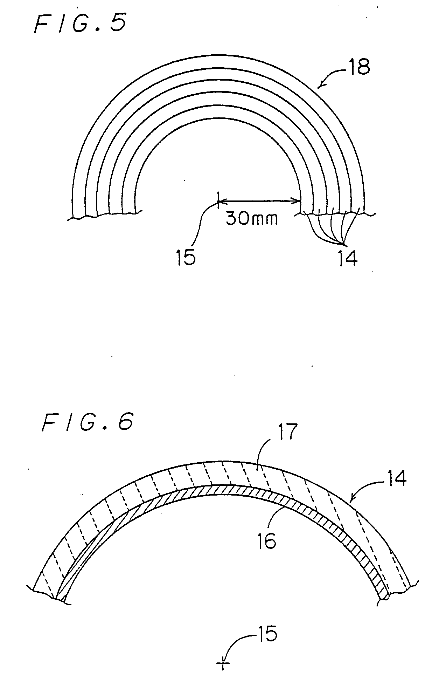

As shown in Fig. 5, the oxide superconductive wire 14 was wound starting from a circumference apart by the radius of 30 mm from the center 15 of a coil 18 for 5 layers, to provide a coil 18. At this time, the oxide superconductive wire was wound with the oxide superconductive layer 16 positioned inside and the longitudinal base 17 positioned outside as shown in Fig. 6.

The coil 18 provided in this manner was dipped in liquid nitrogen, and measured critical current was 23 A.

### Reference Example 2

A coil was fabricated under the same condition as in Embodiment 2 except that the wire was wound with the oxide superconductive layer 16 positioned outside, and the critical current was measured under the same condition, which value was 8 A.

### Reference Example 3

The oxide superconductive wire provided in the embodiment 1 was cut in an appropriate length without winding, and the critical current in the liquid nitrogen of the linear wire was measured, which was 5.2 A.

### Embodiment 3

An oxide superconductive layer of Y₁ Ba₂ Cu₃ O_{7-δ} having the thickness of 2 µm was formed by laser deposition on a tape-type longitudinal base of YSZ (with 9 % Y₂ O₃ added) having the thickness of 50 µm. The conditions of film formation were as follows.
Target composition :Y₁ Ba₂ Cu₃ O_{7-δ}
Temperature of the base: 720°C
Laser peak output: 2 J
Laser pulse width: 15 ns
Laser frequency: 10 Hz
O₂ pressure: 0.01 Torr

Then heat treatment was carried out for 1 hour at 950°C in an O₂ atmosphere.

When the oxide superconductive wire provided in this manner was bent to have a diameter of 40 mm with the oxide superconductive layer positioned inside and the longitudinal base positioned outside, the critical current density was lowered by 8 %.

### Reference Example 4

When the oxide superconductive wire provided under the same condition as in Embodiment 3 was bent to have a diameter of 40 mm with the longitudinal base positioned inside, the critical current density was lowered by more than 90 %.

### Industrial Applicability

As described above, when the oxide superconductive wire is treated in accordance with the present invention, the tensile strain in the oxide superconductive layer included in the oxide superconductive wire can be released and the oxide superconductive wire can be bent without degrading superconductivity of the oxide superconductive layer. Therefore, the present invention can be advantageously applied to products such as coils and cables and intermediate products such as bobbins during manufacturing of which the oxide superconductive wires must be inevitably bent.

## Claims

1. A method for producing an oxide superconducting wire (11; 14) consisting of an oxide superconducting layer (2; 12; 16) on a flexible longitudinal base (1; 13; 17), the thermal expansion coefficient of said longitudinal base (1; 13; 17) being smaller than that of said oxide superconducting layer (2; 12; 16), the method comprising the steps in sequence:
a) applying an oxide superconducting material (2; 12; 16) to said flexible longitudinal base (1; 13; 17) and heating the resulting material/base structure (2, 1; 12, 13; 16, 17) to form an oxide superconducting wire (11; 14);
b) bending said superconducting wire (11; 14) such that said superconducting layer (2; 12; 16) being positioned inside and said longitudinal base being positioned outside around a flexural center (15).

2. The method of producing an oxide superconducting wire according to claim 1, further comprising the step of:
providing said longitudinal base (1; 13; 17) as a tape-type base.

3. A method of producing an oxide superconducting wire according to claim 1 or 2, further comprising the step of:
forming said longitudinal base (1; 13; 17) of a material selected from the group consisting of zirconia, alumina, glass, titanium, zirconium, tungsten, platinum, chromium, nickel, niobium, molybdenum, iron, stainless steel and nickel alloy.

4. The method of producing an oxide superconducting wire according to anyone of the preceding claims, wherein said bending step comprises the step of bending said superconducting wire (14) to form a coil (18).

5. The method of producing an oxide superconducting wire according to anyone of the preceding claims 1 thru 3, wherein said bending step comprises the step of bending said superconducting wire (11) around a core (10) of a bobbin (9).

6. The method of producing an oxide superconducting wire according to anyone of the preceding claims 1 thru 3, wherein said bending step comprises the step of wounding said oxide superconducting wire (11; 14) spirally on a surface of a longitudinal body (9).

## Patentansprüche

1. Verfahren zur Herstellung eines supraleitenden Drahtes (11; 14) auf Oxidbasis bestehend aus einer supraleitenden Oxidschicht (2; 12; 16) auf einer flexiblen, langgestreckten Basis (1; 13; 17), wobei der thermische Expansionskoeffizient der langgestreckten Basis (1; 13; 17) kleiner als der der supraleitenden Oxidschicht ( 2; 12, 16) ist, wobei das Verfahren aufeinanderfolgend die Schritte aufweist:
a) Aufbringen eines supraleitenden Materials (2; 12; 16) auf Oxidbasis auf der flexiblen, langgestreckten Basis (1; 13; 17) und Erhitzen der sich ergebenden Material/Basis-Struktur (2, 1; 12, 13; 16, 17), um einen supraleitenden Draht (11; 14) auf Oxidbasis zu bilden;
b) Biegen des supraleitenden Drahtes (11; 14) derart, daß die supraleitende Schicht (2; 12; 16) in Bezug auf ein Biegezentrum (15) innen und die langestreckte Basis außen positioniert wird.

2. Verfahren zur Herstellung eines supraleitenden Drahtes auf Oxidbasis gemäß Anspruch 1, weiter den Schritt umfassend:
Bereitstellen der langgestreckten Basis (1; 13; 17) als bandartige Basis.

3. Verfahren zur Herstellung eines supraleitenden Drahtes auf Oxidbasis gemäß Anspruch 1 oder 2, weiter den Schritt umfassend:
Bilden der langgestreckten Basis (1; 13; 17) aus einem Material, das aus der Gruppe ausgewählt wurde, die aus Zirkonium(IV)-Oxid, Aluminiumoxid, Glas, Titan, Zirkonium, Wolfram, Platin, Chrom, Nickel, Niob, Molybdän, Eisen, nichtrostendem Stahl und Nickellegierung besteht.

4. Verfahren zur Herstellung eines supraleitenden Drahtes auf Oxidbasis gemäß einem der vorhergehenden Ansprüche, worin der Biegeschritt den Schritt des Biegens des supraleitenden Drahtes (14) zu einer Spule (18) umfaßt.

5. Verfahren zur Herstellung eines supraleitenden Drahtes auf Oxidbasis gemäß einem der vorhergehenden Ansprüche 1 bis 3, worin der Biegeschritt den Schritt des Biegens des supraleitenden Drahtes um einen Kern (10) eines Spulenkörpers (9) umfaßt.

6. Verfahren zur Herstellung eines supraleitenden Drahtes auf Oxidbasis gemäß einem der vorhergehenden Ansprüche 1 bis 3, worin der Biegeschritt den Schritt des spiralförmigen Aufwickelns des supraleitenden Drahtes (11; 14) auf Oxidbasis auf der Oberfläche eines langgestreckten Körpers (9) umfaßt.

## Revendications

1. Procédé pour produire un fil supraconducteur d'oxyde (11, 14) qui est constitué d'une couche supraconductrice d'oxyde (2, 12, 16) sur une base longitudinale élastique (1, 13, 17), le coefficient de dilatation thermique de ladite base longitudinale (1, 13, 17) étant inférieur à celui de ladite couche supraconductrice d'oxyde (2, 12, 16), le procédé comprenant les étapes en séquence consistant à :
a) appliquer un matériau supraconducteur d'oxyde (2, 12, 16) sur ladite base longitudinale élastique (1, 13, 17), et chauffer la structure obtenue matériau/base (2, 1, 12, 13, 16, 17) pour former un fil supraconducteur d'oxyde (11, 14),
b) courber ledit fil supraconducteur (11, 14) de sorte que ladite couche supraconductrice (2, 12, 16) soit positionnée à l'intérieur et que ladite base longitudinale soit positionnée à l'extérieur autour d'un centre de flexion (15).

2. Procédé pour produire un fil supraconducteur d'oxyde selon la revendication 1, comprenant de plus l'étape consistant à fournir ladite base longitudinale en tant que base du type ruban.

3. Procédé pour produire un fil supraconducteur d'oxyde selon la revendication 1 ou 2, comprenant de plus l'étape consistant à former ladite base longitudinale (1, 13, 17) à partir d'un matériau choisi dans le groupe constitué du zircone, de l'alumine, du verre, du titane, du zirconium, du tungstène, de platine, du chrome, du nickel, du niobium, du molybdène, du fer, de l'acier inoxydable et d'alliage de nickel.

4. Procédé pour produire un fil supraconducteur d'oxyde selon l'une quelconque des revendications précédentes, dans lequel l'étape de courbure comprend l'étape consistant à courber ledit fil supraconducteur (14) afin de former une bobine (18).

5. Procédé pour produire un fil supraconducteur d'oxyde selon l'une quelconque des revendications 1 à 3, dans lequel ladite étape de courbure comprend l'étape consistant à courber ledit fil supraconducteur (11) autour d'un noyau (10) d'une bobine (9).

6. Procédé pour produire un fil supraconducteur d'oxyde selon l'une quelconque des revendications 1 à 3, dans lequel ladite étape de courbure comprend l'étape consistant à enrouler ledit fil supraconducteur d'oxyde (11, 14) en spirale sur une surface d'un corps longitudinal (9).
